# EUROPEAN PATENT SPECIFICATION

(11) **EP 2 883 430 B1**
(45) Date of publication and mention of the grant of the patent: **05.10.2022**
(21) Application number: 12882879.5
(22) Date of filing: 10.08.2012
(51) Int. Cl.: H05K 3/40, H05K 3/42

(54) **A PRINTED CIRCUIT BOARD ARRANGEMENT AND A METHOD FOR FORMING ELECTRICAL CONNECTION AT A PRINTED CIRCUIT BOARD**
LEITERPLATTENANORDNUNG UND VERFAHREN ZUR HERSTELLUNG EINER ELEKTRISCHEN VERBINDUNG AN EINER LEITERPLATTE
AGENCEMENT DE CARTE À CIRCUITS IMPRIMÉS ET PROCÉDÉ POUR FORMER UNE CONNEXION ÉLECTRIQUE AU NIVEAU D'UNE CARTE À CIRCUITS IMPRIMÉS

(43) Date of publication of application: 17.06.2015
(73) Proprietor: Telefonaktiebolaget LM Ericsson (publ), 164 83 Stockholm (SE)
(72) Inventor: PEREZ-URIA, Igor, S-176 74 Järfälla (SE); FERM, Per, S-187 50 Täby (SE); GUSTAFSON, Benny, S-163 42 Spånga (SE)
(74) Representative: Zacco Sweden AB
(86) International application number: PCT/SE2012/050868
(87) International publication number: WO 2014/025298

(56) References cited:
- EP-A1- 2 718 968
- EP-A2- 0 591 761
- WO-A1-2012/170625
- DE-A1-102009 028 744
- GB-A- 2 057 195
- JP-A- 2006 179 519
- US-A- 3 148 310
- US-A- 5 401 911
- US-A1- 2006 272 850
- US-A1- 2009 095 520
- US-A1- 2011 278 725
- US-B1- 6 252 779
- US-B2- 6 913 187

## Description

### TECHNICAL FIELD

The present invention relates to printed circuit boards. More particularly, the invention relates to a printed circuit board arrangement and a method for forming electrical connection at a printed circuit board.

### BACKGROUND

Power conversion technology is heading towards higher current density and power while at the same time minimizing. Accordingly, interconnection channels between host board and devices are slimmed to fit miniaturization product demands.

The tendency towards cost effective and tightly denser electronic packaging demands flexibility with regard to component placement on a board (e.g dual side), current distribution and optimal thermal integrity from semiconductor, copper traces, solder joints down to host board.

Harsh application environments (outdoor enclosures or application with limited forced convection) demands optimal thermal design integrity/minimal losses in the power distribution.

US 6 913 187 describes a method of providing thermal vias in a printed circuit board. One or more holes are provided in the printed circuit board. A metal ball is inserted to each hole and subjected to pressure such as to deform the ball and tightly fixating the resultant slug against the wall of the hole. The deformed ball or slug fixed in the hole functions to conduct heat and/or electricity between a metallized top side and bottom side of the printed circuit board.

Electronic devices, such as integrated circuit chips, are commonly attached to a substrate or printed circuit card with ball connecters using a ball grid array (BGA) connection technique. Using the ball grid array usually involves attachment of an array of balls located on the underside of an electronic device to a corresponding array of contact pads located on a surface of a substrate, using individual solder joints. It is known in the art to use copper plated and/or polymer-plated and/or lead free solder spheres in for example ball grid arrays or 3D packaging applications. Solder copper balls placed between host board and device's signal/power source provide an effective/low ohmic interconnection channel.

US 6252779 discloses a method for joining electronic devices such as integrated circuits to vias in a substrate. The method involves providing a substrate have a conductive opening therein and securely positioning an electrically conductive member within the conductive opening to plug the conductive opening.

JP 2006179519 A seems to disclose a method used to manufacture a printed board using a board wherein a through-hole is formed with a conductive covering film on its inner circumferential surface. At least a spherical conductor of which diameter is larger than that of the through hole and wherein the surface of a metallic ball is covered with a solder film, is pressed into the through hole, and then the solder is melted, thus filling the through hole therewith.

### SUMMARY

The invention is defined by the independent claims. One object of the invention is to improve the prior art with respect to current transfer between layers of printed circuit boards.

According to the invention, a printed circuit board arrangement as defined by claim 1 is provided.

One advantage with the present invention is that the electrical connection provides for a reinforced current transfer between layers of the printed circuit board. The currents transferred between layers of a printed circuit board can be increased with maintained or increased package size. Existing limitations in the currents which can be transferred by means of the walls of the passage between the conductive layers of the printed circuit board is remedied by means of the second path passing the at least one first ball.

The electrical connection between the layers is low ohmic. This provides for low power losses and consequently the need for dissipating heat from the connection is less than in conventional connections between layers. Thus, the electrical transfer between layers can be achieved while keeping stress due to temperature limits within acceptable levels. The use of the at least one first ball for the second path is cost effective. The cost for producing the balls having high conductivity is low. The mounting of the electrical connection comprising the at least one first ball is of low complexity and consequently cost effective.

In one option, the at least one first ball has an electrical conductivity σ higher than 3×10⁷ S/m at 20°. The high conductivity of the at least one first ball secures the low resistance of the second path. The first ball comprises in one example copper or a copper alloy.

According to the invention, the electrically conductive material formed on the walls is in low ohmic or low resistance contact with the surface of the at least one first ball. Thereby an electrical path between the wall and at least one first ball forms part of the second electrical path between the first and second conductive layers of the printed circuit board.

According to the invention, the passage is filled or partially filled with solder. The solder provides for the low ohmic or low resistance contact between the wall and the at least one first ball.

In one option, the printed circuit board arrangement comprises a second ball centered against an opening of the passage at the first and/or second side. Each second ball has a diameter larger than the diameter of the passage and is electrically conducting. Thereby the second ball can be used for communication of data and or for power transfer between the printed circuit board and other electrical equipment electrically connected to the second ball. Further, the second ball can also be used for dissipating heat from the printed circuit board. Further, the second ball closes the opening to the passage. In one example, each second ball is soldered to its associated surface. Thus, the opening to the passage is closed by means of soldering.

In one option, at least one electrical device is electrically connected to the printed circuit board by means of the second ball(s). The other electrical device may be a main board or motherboard. The second ball may be centered in an opening formed in the other electrical device so as to provide electrical contact with the other electrical device.

According to the invention, a method as defined by claim 9 is provided

In one option, wherein a plurality of first balls are provided, the step of filling the passage comprises filling the passage with the plurality of first balls so that the passage completely encloses the first balls. Thereby the first balls form a substantial part of the second path.

In one option, the method further comprises the steps of providing an electrically conducting second ball having a diameter larger than the diameter of the passage and self centering the second ball against an opening of the passage at the first side of the printed circuit board.

According to the invention, the method has the step of filling the passage with the at least one first ball and thereafter inserting solder in the passage so as to at least partly fill the passage with the solder.

In one option, the method further comprises the steps of providing another electrically conducting second ball having a diameter larger than the diameter of the passage and self centering that second ball against the passage opening at the second side of the printed circuit board. Each second ball may be fixed to the associated surface for example by means of solder.

Adjacent balls, first and/or second balls, may be fixed to each other for example by means of solder or etching.

In one option, the method comprises further a step of providing electrical contact between the second ball and an electrical conductor of another electrical device. The providing of the electrical contact may comprise centering the second ball in an opening formed in the electrical device.

### BRIEF DESCRIPTION OF THE DRAWINGS

Figure 1 illustrates schematically a side view of a cross section of a part of a printed circuit board according to one example.
Figure 2 illustrates schematically a side view of a cross section of a part of a printed circuit board according to another example.
Fig 3 illustrates schematically a side view of an electrical connection for use in a printed circuit board.
Figure 4 illustrates schematically a side view of a cross section of a part of a printed circuit board according to yet another example.
Fig 5 is a flowchart illustrating one example of a method for forming an electrical connection at a printed circuit board.
Fig 6 is a flowchart illustrating another example of a method for forming an electrical connection at a printed circuit board.

### DETAILED DESCRIPTION

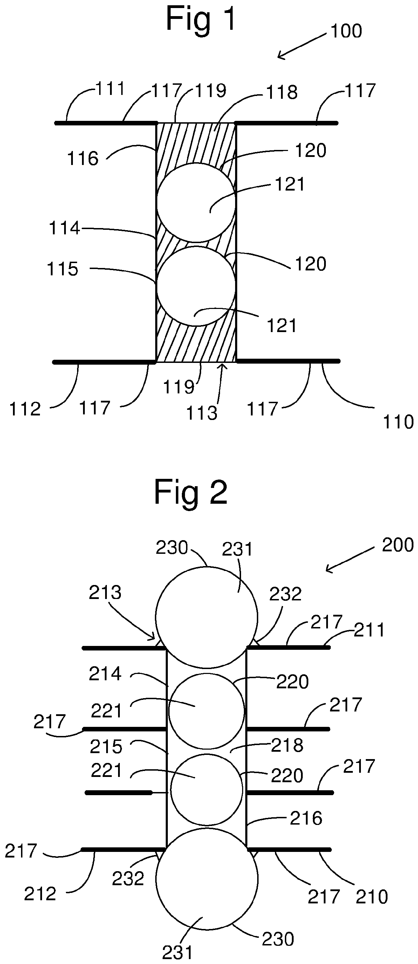

In Fig 1 a printed circuit board arrangement 100 comprises a printed circuit board 110. The printed circuit board 110 has a first side 111 and a second side 112. An electrical connection 113 electrically connects a first conductive layer 117 and a second conductive layer 117 of the printed circuit board.

The respective first and second layers are arranged to transfer power and/or communication signals. The respective first and second layers may also be arranged to transfer heat. The layers may be formed as conductive patterns having one or a plurality of conductive lines and/or conductive areas. The first and second layers are in one example metalized. The metalized first and second layers comprise in one example copper or a copper alloy.

In this particular illustrated example, the first and second layers are formed on the first and second sides, respectively.

The electrical connection 113 comprises a passage 116 extending from an opening 119 in one of the sides 111, 112 of the printed circuit board 110 through the printed circuit board between the first and second layers. In one example the passage is formed as a straight or oblique cylinder. In another example, the passage is shaped as a truncated cone. The cylinder/cone may have a circular cross section. In one example, the passage extends perpendicularly in relation to the printed circuit board sides. In one example (not shown) the passage 116 only partly penetrates the printed circuit board (a blind via).

In this particular illustrated example, the passage 116 extends between an opening in each respective side of the printed circuit board forming a through hole.

Electrically conducting material 114 is formed on the wall 115 of the passage. This electrically conducting material forms a first path electrically connecting the first conductive layer 117 with the second conductive layer 117. In one example, the wall of the passage is completely or partly plated with the electrically conductive material. The thickness of the conductive material formed on the walls of the passage sets the limit for the current level which it is possible to transfer by means of the first electrical path between the first and second layers. In one example, the conductive material formed on the wall comprise in one example copper or a copper alloy.

The passage 116 encloses at least one first ball 120. The at least one first ball 120 is electrically conducting. The at least one first ball forms part of a second electrical path between the first and second conductive layers of the printed circuit board. The second electrical path has a lower resistance than the first path. In one example, the first ball has an electrical conductivity a higher than 3×107 S/m at 20° C. The at least one first ball may comprise copper or a copper alloy. The electrical conductivity is then characteristically 93-96% IACS. In one example, the at least one first ball is solid. A surface 121 of the first ball(s) is in one example plated with plating material. The plating may be present so as to avoid corrosion. The plating material comprises in one example tin, silver, nickel, or gold or a combination of some of these metals. In one example, the surface of the first balls treated with other solderability protectant, e.g. OSP.

The at least one first ball has a size which is equal to or smaller than the length and diameter of the passage. First balls of different shapes may be used. For example, at least some of the first balls are in one example sphere shaped. Other first ball(s) may be of other shapes such as cylinder shaped. According to the invention, at least some of the first ball(s) have one or a plurality of grooves and/or notches and/or channels formed therein. Thereby outgassing, ventilation and/or wetting can be improved. The first balls may be selected so as to harmonize with a desired current and/or load. For example, the size, shape and/or electrical conductivity of the at least one ball can be selected so as to harmonize against a desired current and/or load in the electrical connection. If more than one first ball is used, first balls of different sizes, shapes and/or electrical conductivity can be used so as to harmonize with the desired current/load. If more than one first ball is used, the first ball(s) 120 are in low ohmic or low resistance contact with each other. In one example, the first balls are in direct physical contact with each other.

The first ball(s) 120 is in low ohmic or low resistance contact with the first and second layers, as discussed above. Further, the first ball is in one example in low ohmic or low resistance contact with the electrically conductive material formed on the wall 115. According to the invention, the passage is filled or partially filled with solder 118 so as to achieve this low ohmic/resistance contact between first ball(s) and the wall. In one example the solder material comprises tin (Sn) or a tin alloy.

In Fig 2, a printed circuit board arrangement 200 comprises a printed circuit board 210, as discussed in relation to Figure 1. The printed circuit board 210 has a first side 211 and a second side 212. An electrical connection 213 electrically connects at least a first conductive layer 217 and a second conductive layer 217 of the printed circuit board. In the illustrated example, layers are formed on the surface of each side of the printed circuit board. Further, layers are also formed integrated within the printed circuit board. At least one of the layers integrated within the surface board extend into electrical contact with the passage wall.

As discussed in relation to Fig 1, the electrical connection 213 comprises a passage 216 extending from an opening in one of the sides of the printed circuit board 210 through the printed circuit board between the at least first and second layers.

In this particular illustrated example, the passage 216 extends between an opening in each respective side of the printed circuit board forming a through hole.

As discussed in relation to Fig 1, electrically conducting material 214 is formed on the wall 215 of the passage. This electrically conducting material forms a first path electrically connecting the at least first and second conductive layers 217. The passage 216 encloses at least one first ball 220, as discussed in relation to Figure 1.

A second ball 230 is centered against an opening of the passage 216 at the first and/or second side. In this particular illustrated a second ball 230 is centered against an opening of the passage at both sides of the printed circuit board. Each second ball has a diameter larger than the size of the opening to the passage.

Each second ball 230 is electrically conducting. The at least one second ball may form part of the second electrical path between the at least first and second conductive layers of the printed circuit board, as discussed in relation to Figure 1. In one example, the each second ball has an electrical conductivity σ higher than 3×10⁷ S/m at 20°C. Each second ball may comprise copper or a copper alloy. The electrical conductivity is then characteristically 93-96 IACS. In one example, each second ball is solid. A surface 221 of each second ball is in one example plated with plating material. The plating may be present so as to avoid corrosion. The plating material comprises in one example tin, silver, nickel, palladium or gold or a combination of some of these metals. In one example, the surface of the first balls treated with other solderability protectant, e.g. OSP. Each second ball(s) may have one or a plurality of grooves and/or notches and/or channels formed therein. Thereby outgassing, ventilation and/or wetting can be secured. Each second ball 230 is in one example soldered 232 to its associated surface 211 212 of the printed circuit board.

The printed circuit board arrangement 200 provides for an efficient thermo transport from the printed circuit board and especially the electrical connection 213 to the environment by means of the second ball(s).

Further, the second ball(s) 230 form part of a third electrical path between any of the layers 217 and other equipment electrically connected to the second ball(s). The third electrical path is arranged to transfer electrical power and/or electrical signals.

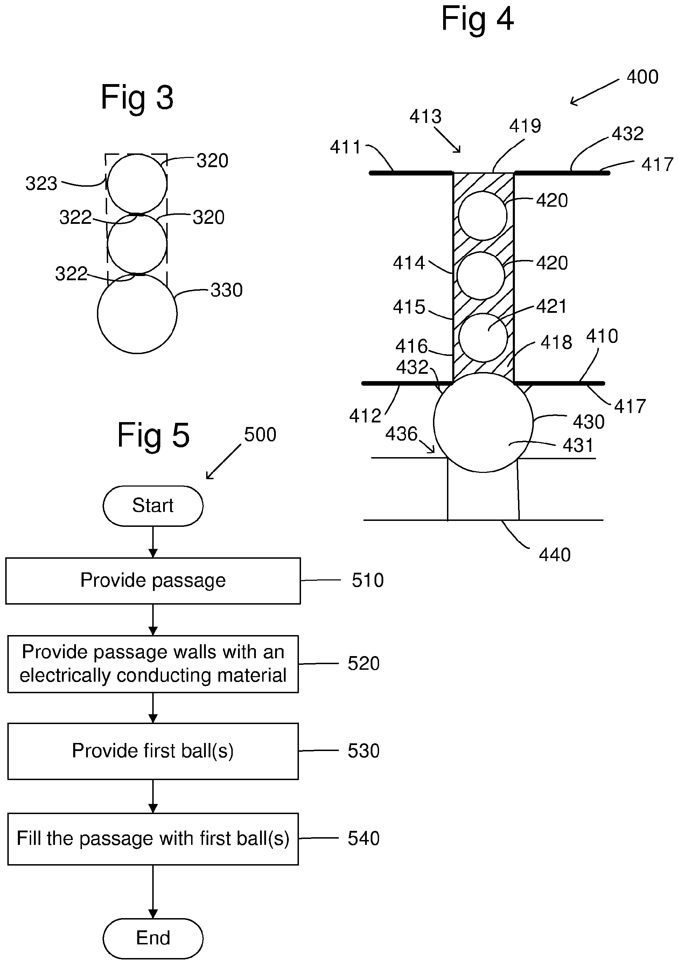

In Fig 4, a printed circuit board arrangement 400 comprises a printed circuit board 410. As discussed in relation to Figures 1 and 2, the printed circuit board 410 has a first side 411 and a second side 412 and an electrical connection 413 electrically connecting a first conductive layer 417 and a second conductive layer 417 of the printed circuit board. The electrical connection 413 comprises a passage 416 extending from an opening 419 in one of the sides of the printed circuit board 410 through the printed circuit board between the first and second layers.

As discussed in relation to Figures 1 and 2, electrically conducting material 414 is formed on the wall 415 of the passage. This electrically conducting material forms a first path electrically connecting the first and second conductive layers 417. The passage 416 encloses a plurality of balls 220, as discussed in relation to Figures 1 and 2.

As discussed in relation to Figure 2, a second ball 430 is centered against an opening in the passage 416 at the second side 412. The second ball 430 has a diameter larger than the size of the opening to the passage. The second ball 430 is electrically conducting. It may form part of the second electrical path between the first and second conductive layers of the printed circuit board, as discussed in relation to Figures 1 and 2. A surface 421 of the second ball is in one example plated with solderable plating material.

Further, the second ball(s) 430 form part of a third electrical path between any of the layers 417 and another electrical device 440 electrically connected to the second ball. The third electrical path is arranged to transfer electrical power and/or electrical signals between the printed circuit board and the other electrical device 440. The third electrical path is in one example also arranged to transfer heat between the printed circuit board and the other electrical device 440. The other electrical device 440 is for example a main board or a motherboard. In the illustrated example, the second ball 430 is centered in an opening 436 formed in the other electrical device so as to provide electrical contact with the other electrical device 440.

This arrangement wherein a plurality of printed circuit boards and/or electrical devices can be mounted on each other by means of the second ball centered in an opening of the respective printed circuit board/electrical device have many advantages. For example, it provides for a predetermined and consistent standoff height between the printed circuit boards and/or electrical devices. Further, it provides for design flexibility as the arrangement allows for selecting the size of the second ball relatively freely as long as the second balls does not fit into the passage 416. Therefore the size of the second ball can be selected to fit with a desired standoff height.

In Fig 3, a plurality of first balls 320 and optionally also a second ball 330 forms a tower of balls for insertion in the passage. Adjacent balls are fixed to each other in fixing points 322 for example by means of etching. Alternatively, the balls are fixed to each other by means of soldering to a carrier 323.

In Fig 5, a method 500 for forming an electrical connection at a printed circuit board comprises the following steps.

In a first step, at least one passage is provided 510 in the printed circuit board extending from an opening in one side of the printed circuit board through the printed circuit board between a first conductive layer and a second conductive layer of the printed circuit board.

Thereafter, the walls of the passage is provided 520 with an electrically conducting material so as to electrically connect the first and second conducting layers of the printed circuit board by means of a first electrical path.

Then, at least one electrically conducting first ball is provided 530. The at least one first ball has a diameter which is equal to or smaller than the length and diameter of the passage.

Thereafter, the at least one first ball is filled 540 in the passage. Thereby, a second electrical path is provided for electrically connecting the first and second conducting layers, wherein the second electrical path has a lower resistance than the first path.

In one example, wherein a plurality of first balls are provided 530, the step of filling 540 the passage comprises filling the passage with the plurality of first balls so that the passage completely encloses the first balls.

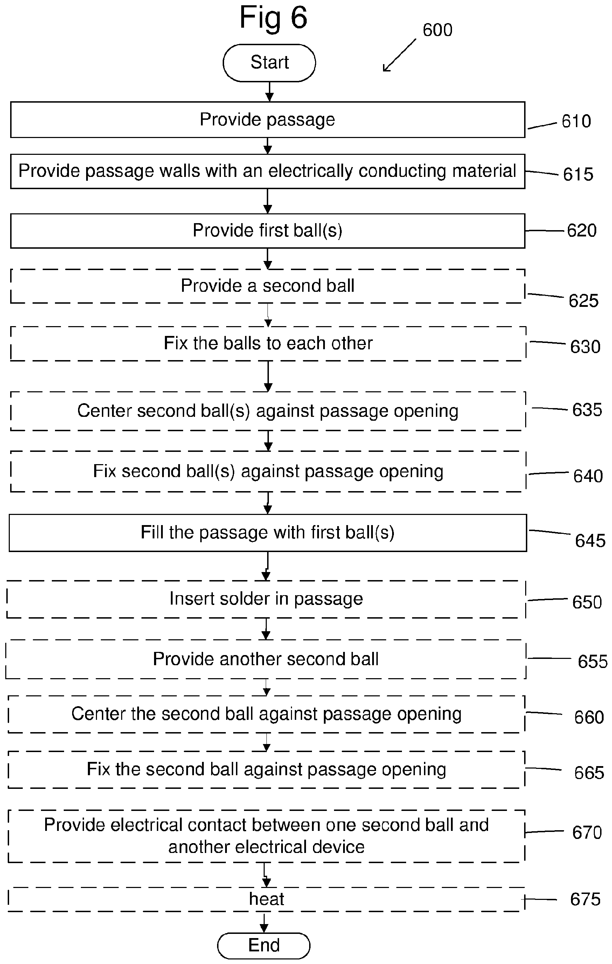

In Fig 6, a method 600 for forming an electrical connection at a printed circuit board comprises the above described steps of providing 610 at least one passage in the printed circuit board, providing 615 the walls of the passage with an electrically conducting material, providing 620 at least one electrically conducting first ball and filling 645 the at least one first ball in the passage.

The method 600 comprises in one example also the steps of providing 625 an electrically conducting second ball having a diameter larger than the diameter of the passage and centering or self centering 635 the second ball against an opening of the passage at the first side of the printed circuit board. The second ball may be fixed 640 to the surface of the printed circuit board for example by means of soldering.

In one example the first balls and optionally also the second ball are fixed 630 to each other before being filled 645 in the passage. In one example, the first balls and optionally also the second ball are etched to each other into a tower of balls of a desired design. Alternatively, the first balls and optionally also the second ball are soldered to a carrier so as to provide to the tower of balls having a desired design.

After the passage has been filled with the first balls, solder is inserted 650 in the passage so as to at least partly fill the passage with the solder.

In the example illustrated in Figure 6, the second ball is first centered 635 and fixed 640 to the surface of the printed circuit board from one side of the printed circuit board, whereupon the first ball(s) are filled from the other, non-plugged side of the printed circuit board. However, the method steps may be peformed in another order. In one example, wherein the opening to the passage is plugged in any permanent or temporary way from one side of the printed circuit board, the first balls may be filled 645 in the passage from the non-plugged side, the solder may inserted 650 in the passage from the non-plugged side and thereafter the second ball is centered 635 and fixed 640 against the passage opening from the non-plugged side of the printed circuit board.

When the passage is filled, it is on one example closed by providing 655 another electrically conducting second ball having a diameter larger than the diameter of the passage and self centering 660 that second ball against the passage opening at the second side of the printed circuit board. Also this other second ball may be fixed 665 to its associated surface for example by means of soldering.

If at least one second ball has been mounted to the printed circuit board the method may further comprise a step of providing 670 electrical contact between the second ball and an electrical conductor of another electrical device. The providing 670 of the electrical contact may comprise centering the second ball in an opening formed in the electrical device.

In one example, the method comprises a one or a plurality of heating steps 675.

## Claims

1. A printed circuit board arrangement (100; 200; 400) comprising:
a printed circuit board (110; 210; 410) having a first side (111; 211; 411) and a second side (112; 212; 412) and an electrical connection (113; 213;4 13) electrically connecting a first conductive layer (117; 217; 417) and a second conductive layer (117; 217; 417) of the printed circuit board (110; 210; 410), the electrical connection (113; 213; 413) comprises:
a passage (116; 216; 416) extending through the printed circuit board (110; 210; 410) from the first side (111; 211; 411) to the second side (112; 212; 412) of the printed circuit board (110; 210; 410) between the first conductive layer (117; 217; 417) and the second conductive layer (117; 217; 417), electrically conducting material (114; 214; 414) formed on walls (115; 215; 415) of the passage (116; 216; 416), said electrically conducting material (114; 214; 414) forming a first path, electrically connecting the first conductive layer (117; 217; 417) with the second conductive layer (117;217;417),and
at least one first ball (120; 220; 420) enclosed by the passage (116; 216; 416), said at least one first ball (120; 220; 420) being electrically conducting, said at least one first ball (120; 220;4 20) having a diameter which is equal to or smaller than the length and diameter of the passage (116; 216; 416), wherein the passage is filled or partially filled with solder so as to achieve a low ohmic/resistance contact between the at least one first ball and the wall;
wherein the at least one first ball (120; 220; 420) forms part of a second electrical path between the first conductive layer (117; 217; 417) and second conductive layer (117; 217; 417) of the printed circuit board (110; 210; 410), said second electrical path having a lower resistance than the first path,
**characterized in that**, said at least one first ball (120; 220; 420) comprises one or a plurality of grooves, notches and/or channels for improving outgassing, ventilation and/or wetting.

2. The printed circuit board arrangement (100; 200; 400) according to claim 1, wherein the at least one first ball (120; 220; 420) has an electrical conductivity σ higher than 3×107 S/m at 20°C.

3. The printed circuit board arrangement (100; 200; 400) according to any of the preceding claims, wherein the first ball (120; 220; 420) comprises copper or a copper alloy.

4. The printed circuit board arrangement (100; 200; 400) according to any of the preceding claims, comprising an electrically conducting second ball (230; 430) centered against an opening (119; 419) of the passage (116; 216; 416) at the first side (111; 211; 411) and/or the second side (112; 212; 412), each second ball (230; 430) having a diameter larger than the diameter of the passage (116; 416).

5. The printed circuit board arrangement (100; 200; 400) according to claim 4, wherein each second ball (230; 430) is soldered (232; 432) to its associated surface (211,212; 411,412).

6. The printed circuit board arrangement (100; 200; 400) according to any of the claims 4 or 5, wherein another electrical device (440) is electrically connected to the printed circuit board (11 0; 210; 410) by means of the second ball(s) (230; 430).

7. The printed circuit board arrangement (100; 200; 400) according to claim 6, wherein the other electrical device (440) is a main board or motherboard.

8. The printed circuit board arrangement (100; 200; 400) according to claim 6 or 7, wherein the second ball (430) is centered in an opening (436) formed in the other electrical device (440) so as to provide electrical contact with the other electrical device (440).

9. A method (500; 600) for forming an electrical connection at a printed circuit board, the method (500; 600) comprising:
- providing (510; 610) at least one passage, extending through the printed circuit board, from a first side to a second side of the printed circuit board between a first conductive layer on the first side and a second conductive layer on the second side;
providing (520; 615) walls of the passage with an electrically conducting material so as to electrically connect the first conductive layer and the second conductive layer of the printed circuit board by means of a first electrical path,
providing (530; 620) at least one electrically conducting first ball having a diameter which is equal to or smaller than the length and diameter of the passage,
- filling (540; 645) the passage with said at least one first ball and thereafter inserting solder in the passage so as to at least partly fill the passage with the solder, wherein said at least one first ball comprises one or a plurality of grooves, notches and/or channels for improving outgassing, ventilation and/or wetting,
performing one or a plurality of heating steps thereby providing a second electrical path for electrically connecting the first conductive layer and the second conductive layer, wherein the second electrical path has a lower resistance than the first path.

10. The method according to claim 9, wherein the passage is filled with the at least one first ball so that the passage completely encloses the at least one first ball.

11. The method according to any of the claims 9 or 10, comprising the steps of providing (625) an electrically conducting second ball having a diameter larger than the diameter of the passage and self centering (635) the second ball against an opening of the passage at the first side of the printed circuit board.

12. The method according to claim 11, further comprising the steps of providing (655) another electrically conducting second ball having a diameter larger than the diameter of the passage and self centering (660) that second ball against the passage opening at the second side of the printed circuit board.

13. The method according to any of the claims 10-12, comprising the steps of providing an electrically conducting second ball having a diameter larger than the diameter of the passage, self centering the second ball against the passage opening at the second side of the printed circuit board adjacent to the at least one first ball, and fixing the at least one first ball and the second ball to each other (630) for example by means of solder or etching.

## Patentansprüche

1. Leiterplattenanordnung (100; 200; 400), umfassend:
eine Leiterplatte (110; 210; 410) mit einer ersten Seite (111; 211; 411) und einer zweiten Seite (112; 212; 412) und einer elektrischen Verbindung (113; 213; 413), die eine erste leitende Schicht (117; 217; 417) und eine zweite leitende Schicht (117; 217; 417) der Leiterplatte (110; 210; 410) elektrisch verbindet, wobei die elektrische Verbindung (113; 213; 413) umfasst:
einen Durchgang (116; 216; 416) der sich durch die Leiterplatte (110; 210; 410) von der ersten Seite (111; 211; 411) zur zweiten Seite (112; 212; 412) der Leiterplatte (110; 210; 410) zwischen der ersten leitenden Schicht (117; 217; 417) und der zweiten leitenden Schicht (117; 217; 417) erstreckt, wobei elektrisch leitendes Material (114; 214; 414) auf Wänden (115; 215; 415) des Durchgangs (116; 216; 416) ausgebildet ist, wobei das elektrisch leitende Material (114; 214; 414) einen ersten Pfad bildet, der die erste leitende Schicht (117; 217; 417) mit der zweiten leitenden Schicht (117; 217; 417) elektrisch verbindet, und
mindestens eine erste Kugel (120; 220; 420), die von dem Durchgang (116; 216; 416) umschlossen ist, wobei die mindestens eine erste Kugel (120; 220; 420) elektrisch leitend ist, wobei die mindestens eine erste Kugel (120; 220; 420) einen Durchmesser aufweist, der gleich oder kleiner als die Länge und der Durchmesser des Durchgangs (116; 216; 416) ist, wobei der Durchgang mit Lot gefüllt oder teilweise gefüllt ist, um einen niederohmigen Kontakt/Kontakt mit geringem Widerstand zwischen der mindestens einen ersten Kugel und der Wand zu erreichen;
wobei die mindestens eine erste Kugel (120; 220; 420) einen Teil eines zweiten elektrischen Pfades zwischen der ersten leitenden Schicht (117; 217; 417) und der zweiten leitenden Schicht (117; 217; 417) der Leiterplatte (110; 210; 410) bildet, wobei der zweite elektrische Pfad einen niedrigeren Widerstand als der erste Pfad aufweist,
**dadurch gekennzeichnet, dass** die mindestens eine erste Kugel (120; 220; 420) eine oder eine Mehrzahl von Rillen, Kerben und/oder Kanälen zur Verbesserung der Ausgasung, Belüftung und/oder Benetzung aufweist.

2. Leiterplattenanordnung (100; 200; 400) nach Anspruch 1, wobei die mindestens eine erste Kugel (120; 220; 420) eine elektrische Leitfähigkeit σ von mehr als 3x107 S/m bei 20 °C aufweist.

3. Leiterplattenanordnung (100; 200; 400) nach einem der vorhergehenden Ansprüche, wobei die erste Kugel (120; 220; 420) Kupfer oder eine Kupferlegierung umfasst.

4. Leiterplattenanordnung (100; 200; 400) nach einem der vorhergehenden Ansprüche, umfassend eine elektrisch leitende zweite Kugel (230; 430), die gegen eine Öffnung (119; 419) des Durchgangs (116; 216; 416) auf der ersten Seite (111; 211; 411) und/oder der zweiten Seite (112; 212; 412) zentriert ist, wobei jede zweite Kugel (230; 430) einen Durchmesser aufweist, der größer als der Durchmesser des Durchgangs (116; 416) ist.

5. Leiterplattenanordnung (100; 200; 400) nach Anspruch 4, wobei jede zweite Kugel (230; 430) mit ihrer zugeordneten Oberfläche (211, 212; 411, 412) verlötet (232; 432) ist.

6. Leiterplattenanordnung (100; 200; 400) nach einem der Ansprüche 4 oder 5, wobei ein weitere elektrische Vorrichtung (440) mittels der/den zweiten Kugel(n) (230; 430) mit der Leiterplatte (110; 210; 410) elektrisch verbunden ist.

7. Leiterplattenanordnung (100; 200; 400) nach Anspruch 6, wobei die andere elektrische Vorrichtung (440) eine Hauptplatine oder ein Motherboard ist.

8. Leiterplattenanordnung (100; 200; 400) nach Anspruch 6 oder 7, wobei die zweite Kugel (430) in einer in der anderen elektrischen Vorrichtung (440) ausgebildeten Öffnung (436) zentriert ist, um einen elektrischen Kontakt mit der anderen elektrischen Vorrichtung (440) bereitzustellen.

9. Verfahren (500; 600) zum Herstellen einer elektrischen Verbindung an einer Leiterplatte, wobei das Verfahren (500; 600) umfasst:
- Bereitstellen (510; 610) mindestens eines Durchgangs, der sich durch die Leiterplatte von einer ersten Seite zu einer zweiten Seite der Leiterplatte zwischen einer ersten leitenden Schicht auf der ersten Seite und einer zweiten leitenden Schicht auf der zweiten Seite erstreckt;
Bereitstellen (520; 615) eines elektrisch leitenden Materials an den Wänden des Durchgangs, um die erste leitende Schicht und die zweite leitende Schicht der Leiterplatte mittels eines ersten elektrischen Pfades elektrisch zu verbinden,
Bereitstellen (530; 620) mindestens einer elektrisch leitenden ersten Kugel mit einem Durchmesser, der gleich oder kleiner ist als die Länge und der Durchmesser des Durchgangs,
- Füllen (540; 645) des Durchgangs mit der mindestens einen ersten Kugel und anschließendes Einführen von Lot in den Durchgang, um den Durchgang zumindest teilweise mit dem Lot zu füllen, wobei die mindestens eine erste Kugel eine oder eine Mehrzahl von Rillen, Kerben und/oder Kanälen zur Verbesserung der Ausgasung, Belüftung und/oder Benetzung aufweist,
Durchführen eines oder einer Mehrzahl von Erwärmungsschritten, wodurch ein zweiter elektrischer Pfad zum elektrischen Verbinden der ersten leitenden Schicht und der zweiten leitenden Schicht bereitgestellt wird, wobei der zweite elektrische Pfad einen niedrigeren Widerstand als der erste Pfad aufweist.

10. Verfahren nach Anspruch 9, wobei der Durchgang mit der mindestens einen ersten Kugel so gefüllt wird, dass der Durchgang die mindestens eine erste Kugel vollständig umschließt.

11. Verfahren nach einem der Ansprüche 9 oder 10, umfassend die Schritte des Bereitstellens (625) einer elektrisch leitenden zweiten Kugel mit einem Durchmesser, der größer als der Durchmesser des Durchgangs ist, und des Selbstzentrierens (635) der zweiten Kugel gegen eine Öffnung des Durchgangs auf der ersten Seite der Leiterplatte.

12. Verfahren nach Anspruch 11, ferner umfassend die Schritte des Bereitstellens (655) einer weiteren elektrisch leitenden zweiten Kugel mit einem Durchmesser, der größer als der Durchmesser des Durchgangs ist, und des Selbstzentrierens (660) dieser zweiten Kugel gegen die Durchgangsöffnung an der zweiten Seite der gedruckten Schaltungsplatte.

13. Verfahren nach einem der Ansprüche 10-12, umfassend die Schritte des Bereitstellens einer elektrisch leitenden zweiten Kugel mit einem Durchmesser, der größer ist als der Durchmesser des Durchgangs, des Selbstzentrierens der zweiten Kugel, benachbart zu der mindestens einen erste Kugel, gegen die Durchgangsöffnung an der zweiten Seite der Leiterplatte, und Befestigen der mindestens einen ersten Kugel und der zweiten Kugel aneinander (630), beispielsweise mittels Löten oder Ätzen.

## Revendications

1. Agencement de carte à circuits imprimés (100 ; 200 ; 400) comprenant :
une carte à circuits imprimés (110 ; 210 ; 410) ayant un premier côté (111 ; 211 ; 411) et un second côté (112 ; 212 ; 412) et une connexion électrique (113 ; 213 ; 413) connectant électriquement une première couche conductrice (117 ; 217 ; 417) et une seconde couche conductrice (117 ; 217 ; 417) de la carte à circuits imprimés (110 ; 210 ; 410), la connexion électrique (113 ; 213 ; 413) comprend :
un passage (116 ; 216 ; 416) traversant la carte à circuits imprimés (110 ; 210 ; 410) du premier côté (111 ; 211 ; 411) au second côté (112 ; 212 ; 412) de la carte à circuits imprimés (110 ; 210 ; 410) entre la première couche conductrice (117 ; 217 ; 417) et la seconde couche conductrice (117 ; 217 ; 417), le matériau électriquement conducteur (114 ; 214 ; 414) étant formé sur les parois (115 ; 215 ; 415) du passage (116 ; 216 ; 416), ledit matériau électriquement conducteur (114 ; 214 ; 414) formant un premier trajet, connectant électriquement la première couche conductrice (117 ; 217 ; 417) à la seconde couche conductrice (117 ; 217 ; 417), et
au moins une première bille (120 ; 220 ; 420) enfermée par le passage (116 ; 216 ; 416), ladite au moins une première bille (120 ; 220 ; 420) étant électriquement conductrice, ladite au moins une première bille (120 ; 220 ; 420) ayant un diamètre égal ou inférieur à la longueur et au diamètre du passage (116 ; 216 ; 416), dans lequel le passage est rempli ou partiellement rempli de soudure afin d'obtenir un contact ohmique/de résistance faible entre l'au moins une première bille et la paroi ;
dans lequel l'au moins une première bille (120 ; 220 ; 420) fait partie d'un second trajet électrique entre la première couche conductrice (117 ; 217 ; 417) et la seconde couche conductrice (117 ; 217 ; 417) de la carte à circuits imprimés (110 ; 210 ; 410), ledit second trajet électrique ayant une résistance inférieure à celle du premier trajet,
**caractérisé en ce que**, ladite au moins une première bille (120 ; 220 ; 420) comprend un(e) ou plusieurs rainures, encoches et/ou canaux pour améliorer le dégazage, la ventilation et/ou le mouillage.

2. Agencement de carte à circuits imprimés (100 ; 200 ; 400) selon la revendication 1, dans lequel l'au moins une première bille (120 ; 220 ; 420) a une conductivité électrique σ supérieure à 3×107 S/m à 20 °C.

3. Agencement de carte à circuits imprimés (100 ; 200 ; 400) selon l'une quelconque des revendications précédentes, dans lequel la première bille (120 ; 220 ; 420) comprend du cuivre ou un alliage de cuivre.

4. Agencement de carte à circuits imprimés (100 ; 200 ; 400) selon l'une quelconque des revendications précédentes, comprenant une seconde bille (230 ; 430) électriquement conductrice centrée contre une ouverture (119 ; 419) du passage (116 ; 216 ; 416) au niveau du premier côté (111 ; 211 ; 411) et/ou du second côté (112 ; 212 ; 412), chaque seconde bille (230 ; 430) ayant un diamètre supérieur au diamètre du passage (116 ; 416).

5. Agencement de carte à circuits imprimés (100 ; 200 ; 400) selon la revendication 4, dans lequel chaque seconde bille (230 ; 430) est soudée (232 ; 432) à sa surface associée (211, 212 ; 411, 412).

6. Agencement de carte à circuits imprimés (100 ; 200 ; 400) selon l'une quelconque des revendications 4 ou 5, dans lequel un autre dispositif électrique (440) est connecté électriquement à la carte à circuits imprimés (110 ; 210 ; 410) au moyen de la ou des seconde(s) bille(s) (230 ; 430).

7. Agencement de carte à circuits imprimés (100 ; 200 ; 400) selon la revendication 6, dans lequel l'autre dispositif électrique (440) est une carte principale ou une carte mère.

8. Agencement de carte à circuits imprimés (100 ; 200 ; 400) selon la revendication 6 ou 7, dans lequel la seconde bille (430) est centrée dans une ouverture (436) formée dans l'autre dispositif électrique (440) afin d'établir un contact électrique avec l'autre dispositif électrique (440).

9. Procédé (500 ; 600) pour former une connexion électrique au niveau d'une carte à circuits imprimés, le procédé (500 ; 600) comprenant :
- la fourniture (510 ; 610) d'au moins un passage, traversant la carte à circuits imprimés, d'un premier côté à un second côté de la carte à circuits imprimés, entre une première couche conductrice sur le premier côté et une seconde couche conductrice sur le second côté ;
la fourniture (520 ; 615) aux parois du passage d'un matériau électriquement conducteur afin de connecter électriquement la première couche conductrice et la seconde couche conductrice de la carte à circuits imprimés au moyen d'un premier trajet électrique,
la fourniture (530 ; 620) d'au moins une première bille électriquement conductrice ayant un diamètre égal ou inférieur à la longueur et au diamètre du passage,
- le remplissage (540 ; 645) du passage avec ladite au moins une première bille et par la suite l'insertion de la soudure dans le passage afin de remplir au moins partiellement le passage avec la soudure, dans lequel ladite au moins une première bille comprend un(e) ou plusieurs rainures, encoches et/ou canaux pour améliorer le dégazage, la ventilation et/ou le mouillage,
l'exécution d'une ou de plusieurs étapes de chauffage fournissant ainsi un second trajet électrique pour connecter électriquement la première couche conductrice et la seconde couche conductrice, dans lequel le second trajet électrique a une résistance inférieure à celle du premier trajet.

10. Procédé selon la revendication 9, dans lequel le passage est rempli avec l'au moins une première bille de sorte que le passage enferme complètement l'au moins une première bille.

11. Procédé selon l'une quelconque des revendications 9 ou 10, comprenant les étapes de fourniture (625) d'une seconde bille électriquement conductrice ayant un diamètre supérieur au diamètre du passage et de centrage automatique (635) de la seconde bille contre une ouverture du passage au niveau du premier côté de la carte à circuits imprimés.

12. Procédé selon la revendication 11, comprenant en outre les étapes de fourniture (655) d'une autre seconde bille électriquement conductrice ayant un diamètre supérieur au diamètre du passage et de centrage automatique (660) de cette seconde bille contre l'ouverture de passage au niveau du second côté de la carte à circuits imprimés.

13. Procédé selon l'une quelconque des revendications 10 à 12, comprenant les étapes de fourniture d'une seconde bille électriquement conductrice ayant un diamètre supérieur au diamètre du passage, de centrage automatique de la seconde bille contre l'ouverture de passage au niveau du second côté de la carte à circuits imprimés adjacente à l'au moins une première bille, et de fixation de l'au moins une première bille et de la seconde bille l'une à l'autre (630) par exemple au moyen d'une soudure ou d'une gravure.
